# EUROPÄISCHE PATENTSCHRIFT

(11) **EP 1 240 585 B1**
(45) Veröffentlichungstag und Bekanntmachung des Hinweises auf die Patenterteilung: **16.07.2003**
(21) Anmeldenummer: 00983061.3
(22) Anmeldetag: 26.10.2000
(51) Int. Cl.: G06F 9/30, G11C 19/18

(54) **REGISTERANORDNUNG EINES MIKROCOMPUTERS MIT EINEM REGISTER UND MIT WEITEREN SPEICHERMITTELN**
REGISTER ARRANGEMENT FOR A MICROCOMPUTER WITH A REGISTER AND FURTHER STORAGE MEDIA
ENSEMBLE REGISTRE D'UN MICRO-ORDINATEUR COMPORTANT UN REGISTRE ET D'AUTRES MOYENS DE MEMORISATION

(30) Priorität: 15.12.1999 DE 19960716
(43) Veröffentlichungstag der Anmeldung: 18.09.2002
(73) Patentinhaber: ROBERT BOSCH GMBH, 70442 Stuttgart (DE)
(72) Erfinder: AUE, Axel, 70825 Korntal-Muenchingen (DE)
(86) Internationale Anmeldenummer: DE0003781
(87) Internationale Veröffentlichungsnummer: WO01044928

(56) Entgegenhaltungen:
- US-A- 3 937 984
- TREMBLAY M ET AL: "VLSI IMPLEMENTATION OF A SHIFT-REGISTER FILE" PROCEEDINGS OF THE ANNUAL HAWAII INTERNATIONAL CONFERENCE ON SYSTEM SCIENCES, 6. Januar 1987 (1987-01-06), XP000603211
- ERCANLI E ET AL: "A REGISTER FILE AND SCHEDULING MODEL FOR APPLICATION SPECIFIC PROCESSOR SYNTHESIS" LAS VEGAS, JUNE 3 - 7, 1996,NEW YORK, IEEE,US, Bd. CONF. 33, 3. Juni 1996 (1996-06-03), Seiten 35-40, XP000640319 ISBN: 0-7803-3294-6

## Beschreibung

### Stand der Technik

Die vorliegende Erfindung betrifft eine Registeranordnung eines Mikrocomputers, mit einem Register, das mindestens ein Registerbit aufweist, und mit weiteren Speichermitteln, die dem Register zugeordnet sind und auf denen der Dateninhalt des Registers zwischenspeicherbar ist.

Ein Mikrocomputer weist eine Vielzahl unterschiedlicher Register auf, um die Verarbeitungsgeschwindigkeit zu erhöhen. So weist beispielsweise der Mikroprozessor eines Mikrocomputers in seiner Ausführungs-Einheit ein Daten-Register und ein Adress-Register auf. Zur Gleitkomma-Rechnung weist der Prozessor in der Floating Point Unit (FPU) und zum Rechnen mit ganzen Zahlen in der Integer Unit (IU) mehrere Register auf (sog. Rechenregister). Darüber hinaus verfügt ein Mikroprozessor auch über sog. Befehlsregister.

In den Registern werden von auf dem Mikrocomputer ablaufenden Anwendungen Daten abgelegt. Wenn eine Anwendung, die ein Register beansprucht, von einer höherpriorisierten Anwendung unterbrochen wird, die dasselbe Register beanspruchen möchte, muss das Register möglichst schnell und ohne Datenverlust für die höherpriorisierte Anwendung freigemacht werden. Dazu werden die in dem Register abgelegten Daten der niederpriorisierten Anwendung in weiteren Speichermitteln zwischengespeichert. Nach dem Stand der Technik sind die weiteren Speichermittel bspw. als ein Stack ausgebildet, auf den die Daten des Registers gerettet werden. Die höherpriorisierte Anwendung kann ihre Daten dann in dem Register ablegen. Nach Beendigung der höherpriorisierten Anwendung werden die auf den Stack geretteten Daten zurück in das Register geladen und die unterbrochene, niederpriorisierte Anwendung wird fortgesetzt.

Es ist denkbar, dass mehrere verschieden priorisierte Anwendungen ineinander verschachtelt ausgeführt werden, so dass auf dem Stack zeitweilig die Daten mehrerer unterbrochener Anwendungen abgelegt sind. Insbesondere bei Mikrocomputern zur Echtzeitverarbeitung werden niederpriorisierte Anwendungen von Zeit zu Zeit von höherpriorisierten Anwendungen unterbrochen und müssen die Daten von den niederpriorisierten Anwendungen aus dem Register auf einen Stack gerettet werden. Zur Unterbrechung der niederpriorisierten Anwendung werden in der Regel Interrupts verwendet.

Das Retten des Inhalts eines Registers auf einem Stack beansprucht jedoch relativ viele Takte des Rechnerkerns. Dadurch kann es nach der Unterbrechung einer niederpriorisierten Anwendung während der Rettung des Dateninhalts des Registers auf einen Stack zu einer Verzögerung kommen, bevor das Register frei ist, die höherpriorisierte Anwendung abgearbeitet werden kann und ihre eigentliche Aufgaben erledigen kann.

Eine Möglichkeit, diese Verzögerung einer höherpriorisierten Anwendung zu verringern bzw. zu vermeiden besteht darin, die weiteren Speichermittel als Registerbänke auszubilden, d. h. die Register des Mikrocomputers mehrfach auszuführen. Zwar lassen sich die Daten aus dem Register bei Bedarf in sehr kurzer Zeit mit relativ wenigen Takten auf die Registerbänke retten. Allerdings sind die Registerbänke als vollständige Register ausgebildet. Da die Flip-Flops relativ viel Fläche beanspruchen, benötigen die Registerbänke dementsprechend viel Siliziumfläche. Aus Platz- und aus Kostengründen ist es jedoch erstrebenswert, einen Mikroprozessor auf einer möglichst geringen Siliziumfläche zu realisieren bzw. auf derselben Fläche möglichst viele Register unterzubringen.

Aus den vorgenannten Nachteilen des Standes der Technik ergibt sich die Aufgabe der vorliegenden Erfindung, eine Registeranordnung der eingangs genannten Art dahingehend auszugestalten und weiterzubilden, dass einerseits die Rechenzeit zum Retten des Dateninhalts des Registers reduziert wird, andererseits aber die für die Registeranordnung benötigte Siliziumfläche möglichst gering ist.

Zur Lösung dieser Aufgabe schlägt die Erfindung ausgehend von der Registeranordnung der eingangs genannten Art vor, dass die weiteren Speichermittel als mindestens ein Schieberegister mit mindestens zwei Schieberegisterzellen ausgebildet sind, wobei der Inhalt einer beliebigen Schieberegisterzelle eines Schieberegisters in das diesem Schieberegister zugeordnete Registerbit und umgekehrt der Inhalt eines Registerbits in eine beliebige Schieberegisterzelle des diesem Registerbit zugeordneten Schieberegisters übertragen werden kann.

In der DE 196 11 520 A1 ist des Weiteren ein IDDQ Test für einen Rechner beschrieben, wobei eine Steuereinheit Mittel enthält, die den Rechner in bestimmte Betriebszustände überführen können. Weiterhin sind Erfassungsmittel vorhanden, die den Strom oder die Spannung im Spannungsversorgungskreis des Rechners erfassen, woraufhin in Vergleichsmitteln der erfaßte Strom oder die erfaßte Spannung mit wenigstens einem vorgegebenen Schwellwert verglichen wird. Zur Betätigung der Anzeigevorrichtung und/oder des Abschaltens gibt es Betätigungsmittel, die abhängig von dem Vergleichsergebnis gegebenenfalls einen Fehler zur Anzeige bringen oder in Reaktion auf einen solchen Fehler die Abschaltung des gesamten Systems oder Teilbereiche des Systems veranlassen.

### Vorteile der Erfindung

Bei der erfindungsgemäßen Registeranordnung ist das Register also nicht mehrfach ausgeführt, sondern zum Retten des Dateninhalts des Registers lediglich mit mindestens einem zusätzlichen Schieberegister versehen. Schieberegister benötigen außerdem eine wesentlich kleiner Siliziumfläche als bzgl. Speicherplatz gleichwertige Registerbänke. Deshalb benötigt die erfindungsgemäße Registeranordnung eine besonders kleine Siliziumfläche.

Gleichzeitig werden zum Retten des Dateninhalts des Registers in das Schieberegister wesentlich weniger Takte benötigt als beim Stand der Technik, wo der Inhalt des Registers auf einen Stack gerettet wird.

Die erfindungsgemäße Registeranordnung beansprucht also einerseits besonders wenige Takte des Rechnerkerns zum Retten des Dateninhalts des Registers und andererseits aber eine besonders kleine Siliziumfläche.

Werden schließlich vorteilhafterweise in der erfindungsgemäßen Registeranordnung ausschließlich statische Strukturen (CMOS-Architektur) verwendet, so kann die Funktionsfähigkeit des Mikrocomputers auch mit Hilfe des sog. IDDQ-Tests überprüft werden. Der IDDQ-Test beruht auf der physikalischen Tatsache, dass fehlerfreie CMOS-Schaltungen in einem Ruhezustand einen äußerst geringen Stromverbrauch aufweisen. Ein Fehler in der CMOS-Schaltung kann zu einem signifikanten Anstieg des Stromverbrauchs führen. Der IDDQ-Test wird ausführlich beschrieben im Internet auf den Seiten http://www.cedcc.psu.edu/ee497f/rassp_43/sld072.htm bis http://www.cedcc.psu.edu/ee497f/rassp_43/sld080.htm (Stand 14.12.1999), auf die hier ausdrücklich Bezug genommen wird.

Gemäß einer vorteilhaften Weiterbildung der vorliegenden Erfindung wird vorgeschlagen, dass jedem Registerbit des Registers ein Schieberegister zugeordnet ist. Gemäß dieser Weiterbildung kann der Inhalt eines beliebigen Registerbits bei Bedarf in das dem Registerbit zugeordnete Schieberegister verschoben werden. Das Retten des Dateninhalts des Registers in die Schieberegister wird dadurch entscheidend vereinfacht und beschleunigt.

Gemäß einer bevorzugten Ausführungsform der vorliegenden Erfindung wird vorgeschlagen, das jede Schieberegisterzelle nach Art eines Charged-Coupled-Device (CCD)-Elements ausgebildet ist. Es wird insbesondere vorgeschlagen, dass jede Schieberegisterzelle einen Zellen-Transfer-Gate, einen Ladungsspeicher und einen Inverter aufweist. Eine derart ausgebildete Schieberegisterzelle stellt kein vollständiges Flip-Flop dar und benötigt dementsprechend weniger Siliziumfläche. Dennoch können die Speicherzellen des erfindungsgemäßen Schieberegisters den Inhalt eines Registerbits schnell und zuverlässig empfangen, zumindest für die Dauer der Beanspruchung des Registers durch eine höherpriorisierte Anwendung zwischenspeichern und nach Beendigung der höherpriorisierten Anwendung schnell und zuverlässig wieder in das Registerbit übertragen.

Der Inverter umfasst vorzugsweise zwei in Reihe geschaltete Transistoren. Der Zellen-Transfer-Gate umfasst vorteilhafterweise mindestens einen Transistor. Der Ladungsspeicher der erfindungsgemäßen Schieberegisterzelle ist vorzugsweise als eine Gatekapazität des Inverters ausgebildet. Alternativ kann der Ladungsspeicher auch als eine separate Kapazität ausgebildet sein. Die Schieberegisterzelle weist gemäß dieser bevorzugten Ausführungsform also lediglich drei Transistoren auf. Im Gegensatz dazu weist beispielsweise eine SRAM-Speicherzelle sechs oder vier Transistoren auf. Eine DRAM-Zelle hat zwar nur einen Transistor, benötigt aber eine umfangreiche Refresh-Logik.

Gemäß einer bevorzugten Ausführungsform der vorliegenden Erfindung wird vorgeschlagen, dass zwischen dem Register und der ersten Schieberegisterzelle ein Eingangs-Transfer-Gate angeordnet ist. Gemäß einer weiteren bevorzugten Ausführungsform der Erfindung wird vorgeschlagen, dass die letzte Schieberegisterzelle über einen Ausgangs-Transfer-Gate mit der ersten Schieberegisterzelle verbunden ist. Durch öffnen des Ausgangs-Transfer-Gates kann der Inhalt der letzten Schieberegisterzelle in die erste Schieberegisterzelle verschoben werden, sofern deren Transfer-Gate geöffnet ist. Falls der Transfer-Gate der ersten Schieberegisterzelle geschlossen und der Eingangs-Transfer-Gate geöffnet ist, kann auch der Inhalt der letzten Schieberegisterzelle direkt in das Registerbit zu verschieben, dem das Schieberegister zugeordnet ist.

Die Zellen-Transfer-Gates sind mit einem Taktgeber verbunden, um die Dateninhalte der Schieberegisterzellen im Takt des Taktgebers von einer Schieberegisterzelle zu der nächsten zu verschieben. Ebenso sind der Eingangs-Transfer-Gate und der Ausgangs-Transfer-Gate vorteilhafterweise mit einem Taktgeber verbunden. Indem die verschiedenen Transfer-Gates des Schieberegisters im Takt des Taktgebers angesteuert, d.h. geöffnet oder geschlossen, werden, können die Dateninhalte des Registers empfangen, innerhalb des Schieberegisters beliebig hin- und herverschoben und wieder an das Register übertragen werden. Der Taktgeber wird von dem Systemtakt des Mikrocomputers oder einem Vielfachen davon getaktet.

### Zeichnungen

Ein bevorzugtes Ausführungsbeispiel der vorliegenden Erfindung wird im Folgenden anhand der Zeichnungen näher erläutert. Es zeigen:
- Figur 1: eine erfindungsgemäße Registeranordnung gemäß einer bevorzugten Ausführungsform; und
- Figur 2: eine Schieberegisterzelle eines Schieberegisters aus Figur 1 im Ausschnitt.

### Ausführungsbeispiel

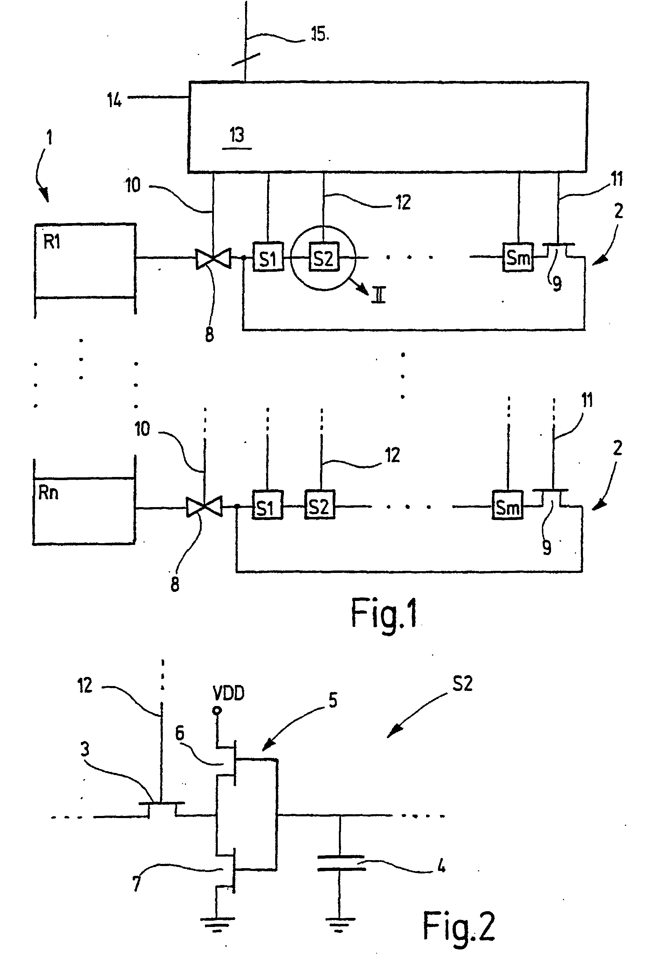

In Figur 1 ist eine erfindungsgemäße Registeranordnung dargestellt. Sie weist ein Register 1 mit mehreren Registerbits R1 bis Rn auf. Jedem Registerbit R1 bis Rn ist ein Schieberegister 2 mit mehreren Schieberegisterzellen S1, S2 bis Sm zugeordnet.

Der Aufbau einer Schieberegisterzelle S1 bis Sm wird nachfolgend unter Bezugnahme auf Figur 2 näher erläutert, wo die Schieberegisterzelle S2 des dem ersten Registerbit R1 zugeordneten Schieberegister 2 vergrößert dargestellt ist. Die übrigen Schieberegisterzellen sind entsprechend aufgebaut. Die Schieberegisterzelle S2 ist nach Art eines Charged-Coupled-Device (CCD)-Elements ausgebildet. Die Schieberegisterzelle S2 weist einen Zellen-Transfer-Gate 3, einen Ladungsspeicher 4 und einen Inverter 5 auf. Der Zellen-Transfer-Gate 3 ist als ein Transistor ausgebildet. Der Inverter 5 umfasst zwei in Reihe geschaltete Transistoren 6, 7. Der Transistor 6 ist als ein pmos-Transistor und der Transistor 7 als ein nmos-Transistor ausgebildet. Der Transistor 6 ist mit seiner Source an die Versorgungsspannung VDD und der Transistor 7 mit seinem Drain an Masse angeschlossen. Der Ladungsspeicher 4 ist als eine Gatekapazität des Inverters 5 ausgebildet. Alternativ kann er auch als eine separate Kapazität ausgebildet sein.

Zwischen dem Register 1 und den ersten Schieberegisterzellen S1 der Schieberegister 2 ist jeweils ein Eingangs-Transfer-Gate 8 angeordnet. Die letzte Schieberegisterzellen Sm der Schieberegister 2 sind jeweils über einen Ausgangs-Transfer-Gate 9 mit der ersten Schieberegisterzelle S1 des jeweiligen Schieberegisters 2 verbunden. Der Eingangs-Transfer-Gate 8 ist über eine Eingangs-Taktleitung 10, der Ausgangs-Transfer-Gate 9 über eine Ausgangs-Taktleitung 11 und der Zellen-Transfer-Gate 3 der Schieberegisterzellen S1 bis Sm über eine Taktleitung 12 mit einem Taktgeber 13 verbunden. Der Taktgeber 13 erhält den Zeittakt von einer Systemuhr 14 des Mikrocomputers. Durch eine entsprechende Ansteuerung der Transfer-Gates 3, 8, 9 über die Taktleitungen 10, 11, 12 können die Dateninhalte des Registers 1 in die Schieberegister 2 gerettet, die dort abgelegten Daten beliebig hin- und herverschoben und die Dateninhalte dann wieder aus den Schieberegistern 2 in das Register 1 übertragen werden. Der Inhalt der Registerbits R1 bis Rn kann somit in einer beliebigen Schieberegisterzelle S1 bis Sm des dem jeweiligen Registerbit R1 bis Rn zugeordneten Schieberegisters 2 abgelegt und umgekehrt aus einer beliebigen Schieberegisterzelle S1 bis Sm auch wieder zurück in das Registerbit R1 bis Rn übertragen werden.

Bei einem Schieberegister 2 dauert das Verschieben des Inhalts von einer Schieberegisterzelle S1 bis Sm in die nächste bspw. 5 ns. Falls der Dateninhalt der Schieberegisterzellen S1 bis Sm nur in eine Richtung verschoben werden kann, ergibt sich bei einem Schieberegister 2 mit zehn Schieberegisterzellen S1 bis Sm eine maximale Zugriffszeit auf den Dateninhalt einer Schieberegisterzelle S1 bis Sm von 50 ns. Welches der Schieberegister 2 durch den Taktgeber 13 zu einem bestimmten Zeittakt angesteuert werden soll, wird mittels einer Register-File-Select-Leitung 15 festgelegt.

Jeweils die ersten Schieberegisterzellen S1 der Schieberegister 2 bilden eine erste Registerbank. Ebenso bilden die zweiten Schieberegisterzellen S2 der Schieberegister 2 eine zweite Registerbank bis hin zu den letzten Schieberegisterzellen Sm, die eine m-te Registerbank bilden. Allerdings benötigen die aus den Schieberegisterzellen S1 bis Sm aufgebauten Registerbänke eine besonders kleine Siliziumfläche, da die einzelnen Schieberegisterzellen S1 bis Sm nicht als vollständige Flip-Flops ausgebildet sind und lediglich drei Transistoren 3, 6, 7 aufweisen. Dadurch kann der Platzbedarf der erfindungsgemäßen Registeranordnung vermindert und die Herstellungskosten können aufgrund der benötigten kleinen Siliziumfläche gering gehalten werden.

## Patentansprüche

1. Registeranordnung eines Mikrocomputers, mit einem Register (1), das mindestens ein Registerbit (R1 bis Rn) aufweist, und mit weiteren Speichermitteln, die dem Register (1) zugeordnet sind und auf denen der Dateninhalt des Registers (1 zwischenspeicherbar ist, **dadurch gekennzeichnet, dass** die weiteren Speichermittel als mindestens ein Schieberegister (2) mit mindestens zwei Schieberegisterzellen (S1 bis Sm) ausgebildet sind, wobei der Inhalt einer beliebigen Schieberegisterzelle (S1 bis Sm) eines Schieberegisters (2) in das diesem Schieberegister (2) zugeordnete Registerbit (R1 bis Rn) und umgekehrt der Inhalt eines Registerbits (R1 bis Rn) in eine beliebige Schieberegisterzelle (S1 bis Sm) des diesem Registerbit (R1 bis Rn) zugeordneten Schieberegisters (2) gebracht werden kann.

2. Registeranordnung nach Anspruch 1, **dadurch gekennzeichnet, dass** jedem Registerbit (R1 bis Rn) des Registers (1) ein Schieberegister (2) zugeordnet ist.

3. Registeranordnung nach Anspruch 1 oder 2, **dadurch gekennzeichnet, dass** jede Schieberegisterzelle (S1 bis Sm) nach Art eines Charged-Coupled-Device (CCD)-Elements ausgebildet ist.

4. Registeranordnung nach Anspruch 3, **dadurch gekennzeichnet, dass** jede Schieberegisterzelle (S1 bis Sm) einen Zellen-Transfer-Gate (3), einen Ladungsspeicher (4) und einen Inverter (5) aufweist.

5. Registeranordnung nach Anspruch 4, **dadurch gekennzeichnet, dass** der Zellen-Transfer-Gate (3) mindestens einen Transistor umfaßt.

6. Registeranordnung nach Anspruch 4 oder 5, **dadurch gekennzeichnet, dass** der Ladungsspeicher (4) als eine Gatekapazität des Inverters (5) oder als eine separate Kapazität ausgebildet ist.

7. Registeranordnung nach einem der Ansprüche 1 bis 6, **dadurch gekennzeichnet, dass** zwischen dem Register (1) und der ersten Schieberegisterzelle (S1) ein Eingangs-Transfer-Gate (8) angeordnet ist.

8. Registeranordnung nach Anspruch 7, **dadurch gekennzeichnet, dass** die letzte Schieberegisterzelle (Sm) über einen Ausgangs-Transfer-Gate (9) mit der ersten Schieberegisterzelle (S1) verbunden ist.

9. Registeranordnung nach Anspruch 8, **dadurch gekennzeichnet, dass** der Eingangs-Transfer-Gate (8) und der Ausgangs-Transfer-Gate (9) mit einem Taktgeber (13) verbunden sind.

## Claims

1. Register arrangement in a microcomputer, having a register (1) which has at least one register bit (R1 to Rn) and having further storage means which are associated with the register (1) and can be used to buffer-store the data content of the register (1), **characterized in that** the further storage means are in the form of at least one shift register (2) having at least two shift register cells (S1 to Sm), with the content of any shift register cell (S1 to Sm) in a shift register (2) being able to be put into the register bit (R1 to Rn) associated with this shift register (2) and, conversely, the content of a register bit (R1 to Rn) being able to be put into any shift register cell (S1 to Sm) in the shift register (2) associated with this register bit (R1 to Rn).

2. Register arrangement according to Claim 1, **characterized in that** each register bit (R1 to Rn) in the register (1) has an associated shift register (2).

3. Register arrangement according to Claim 1 or 2, **characterized in that** each shift register cell (S1 to Sm) is designed in the manner of a charge-coupled device (CCD) element.

4. Register arrangement according to Claim 3, **characterized in that** each shift register cell (S1 to Sm) has a cell transfer gate (3), a charge store (4) and an inverter (5).

5. Register arrangement according to Claim 4, **characterized in that** the cell transfer gate (3) comprises at least one transistor.

6. Register arrangement according to Claim 4 or 5, **characterized in that** the charge store (4) is in the form of a gate capacitance of the inverter (5) or in the form of a separate capacitance.

7. Register arrangement according to one of Claims 1 to 6, **characterized in that** an input transfer gate (8) is arranged between the register (1) and the first shift register cell (S1).

8. Register arrangement according to Claim 7, **characterized in that** the last shift register cell (Sm) is connected to the first shift register cell (S1) via an output transfer gate (9).

9. Register arrangement according to Claim 8, **characterized in that** the input transfer gate (8) and the output transfer gate (9) are connected to a clock generator (13).

## Revendications

1. Dispositif de registres d'un micro-ordinateur comprenant un registre (1) qui présente au moins un bit de registre (R1 à Rn) et d'autres moyens de mémoire qui sont associés au registre (1) et sur lesquels le contenu de données du registre (1) peut être mémorisé temporairement,
**caractérisé en ce que**
les autres moyens de mémoire sont constitués sous la forme d'au moins un registre à décalage (2) possédant au moins deux cellules de registre à décalage (S1 à Sm), le contenu d'une cellule quelconque (S1 à Sm) d'un registre à décalage (2) pouvant être transféré dans le bit de registre (R1 à Rn) associé à ce registre à décalage (2) et le contenu d'un bit de registre (R1 à Rn) pouvant à l'inverse être transféré dans une cellule quelconque (S1 à Sm ) du registre à décalage (2) associé à ce bit de registre (R1 à Rn).

2. Dispositif de registres selon la revendication 1,
**caractérisé en ce qu'**
un registre à décalage (2) est associé à chaque bit de registre (R1 à Rn) du registre (1).

3. Dispositif de registres selon la revendication 1 ou 2,
**caractérisé en ce que**
chaque cellule de registre à décalage (S1 à Sm) est constituée à la façon d'un élément Charged-Couplet-Device (CCD).

4. Dispositif de registres selon la revendication 3,
**caractérisé en ce que**
chaque cellule de registre à décalage (S1 à Sm) comprend une porte de transfert de cellule (3), une mémoire de charge (4) et un inverseur (5).

5. Dispositif de registres selon la revendication 4.
**caractérisé en ce que**
la porte de transfert de cellule (3) comprend au moins un transistor.

6. Dispositif de registres selon la revendication 4 ou 5,
**caractérisé en ce que**
la mémoire de charge (4) est réalisée sous la forme d'une capacité de porte de l'inverseur (5) ou d'une capacité séparée.

7. Dispositif de registres selon une des revendications 1 à 6,
**caractérisé en ce qu'**
une porte de transfert d'entrée (8) est disposée entre le registre (1) et la première cellule de registre à décalage (S1).

8. Dispositif de registres selon la revendication 7,
**caractérisé en ce que**
la dernière cellule de registre à décalage (Sm) est reliée à la première cellule de registre à décalage (SI) par l'intermédiaire d'une porte de transfert de sortie (9).

9. Dispositif de registres selon la revendication 8,
**caractérisé en ce que**
la porte de transfert d'entrée (8) et la porte de transfert de sortie (9) sont reliées à un générateur de rythme (13).
